# EUROPEAN PATENT APPLICATION

(11) **EP 4 682 153 A1**
(43) Date of publication of application: **21.01.2026**
(21) Application number: 24770850.6
(22) Date of filing: 11.03.2024
(51) Int. Cl.: C07F 15/00, C23C 16/00

(54) **COMPOSITION, METHOD FOR STORING COMPOSITION, AND COMPOUND**

(30) Priority: 13.03.2023 JP 2023039129; 13.03.2023 JP 2023039130
(71) Applicant: JSR Corporation, Tokyo 105-8640 (JP)
(72) Inventor: SHIMIZU, Makoto, Tokyo 105-8640 (JP); SHIHO, Hiroshi, Tokyo 105-8640 (JP); KIMURA, Naoto, kyoto-shi, Kyoto 606-0804 (JP); SAKIMOTO, Jun, kyoto-shi, Kyoto 606-0804 (JP)
(74) Representative: Becker, Eberhard
(86) International application number: PCT/JP2024/009371
(87) International publication number: WO 2024/190744

(57) **Abstract**

The composition contains: at least one compound selected from the group consisting of a first compound represented by formula (2) and a second compound having a metal atom and a ligand represented by formula (1); and an aqueous solvent.

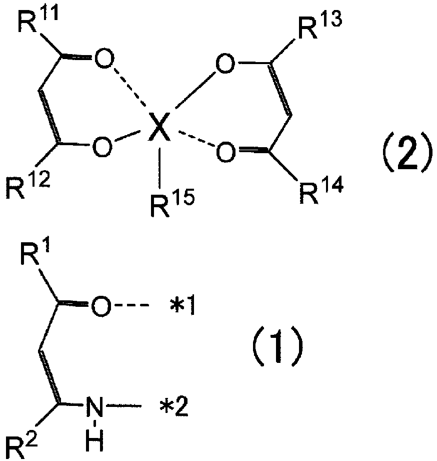

## Description

### Technical Field

The present invention relates to a composition, a method for storing a composition, and a compound.

### Related Art

As a thin film electrode material of various semiconductor devices such as dynamic random access memory (DRAM) and ferroelectric random access memory (FeRAM), a thin film containing a metal such as iridium, gallium, and indium or a metal compound may be used. As a method for manufacturing a metal-containing thin film, for example, a chemical vapor deposition method such as chemical vapor deposition (CVD) and atomic layer deposition (ALD) may be applied.

Many metal complexes have been conventionally known as a raw material compound used in chemical vapor deposition. For example, there is known an iridium complex containing, as a ligand, cyclopentadiene or cyclopentadienyl ligand being a derivative thereof. For example, Patent Document 1 describes a method for manufacturing an iridium-containing thin film using, as a raw material for chemical vapor deposition, (1-methylcyclopentadienyl)(1,5-cyclooctadiene)iridium in which 1-methylcyclopentadienyl and 1,5-cyclooctadiene are coordinated. Patent Document 2 describes a method for manufacturing an iridium-containing thin film using, as a raw material for chemical vapor deposition, (1-ethylcyclopentadienyl)(1,3-cyclohexadiene) in which 1-ethylcyclopentadienyl and 1,3-cyclohexadiene are coordinated.

### Prior Art Documents

### Patent Documents

Patent Document 1: Japanese Patent Laid-open No. 2001-181841
Patent Document 2: Japanese Patent Laid-open No. 2005-232142

### SUMMARY OF INVENTION

### Technical Problem

In chemical vapor deposition, a metal-containing thin film is manufactured by vaporizing a raw material composed of a metal complex, transporting a generated raw material gas to a substrate surface, and decomposing the metal complex. Heating is generally performed for decomposition of the metal complex on the substrate surface. A reaction gas such as oxygen may be mixed with the raw material gas, and the metal complex may be decomposed by the action of the reaction gas along with heating. Furthermore, excitation energy such as plasma may also be used.

The metal complex constituting the above-mentioned conventional raw material for chemical vapor deposition has high thermal stability and can be transported onto a substrate in a stable state even after vaporization. However, conventional metal complexes have several problems due to their high thermal stability.

Conventional metal complexes have a ligand with a bulky substituent to impart thermal stability, resulting in poor solubility in an aqueous solvent. Particularly, in many cases, the conventional metal complexes do not dissolve unless an organic solvent is used. Since high temperature treatment is performed during thin film formation, there are problems such as ignition of the organic solvent, leading to restrictions on usage conditions. On the other hand, there is also a problem that, when the amount of organic solvent used is reduced, solubility may be reduced, and metal complexes may be precipitated during storage. When metal complexes are precipitated, irregularities occur on a surface of the metal-containing thin film, causing deterioration in the performance of the metal-containing thin film.

Thus, while metal complexes have problems of flammability during use and storage stability during storage, the present inventors considered that (1) flammability can be reduced by dissolving the metal complexes in an aqueous solvent, and (2) the storage stability problem caused by reduced solubility that may occur by adopting an aqueous solvent can be solved by examining a ligand of the metal complex, and proceeded with intensive research.

An object of the present invention is to provide a composition excellent in both solubility in an aqueous solvent and storage stability, a method for storing a composition, and a compound.

### Solution to Problem

The invention made to solve the above problems is a composition containing: at least one compound selected from the group consisting of a first compound represented by formula (2) below and a second compound having a metal atom and a ligand represented by formula (1) below; and an aqueous solvent. 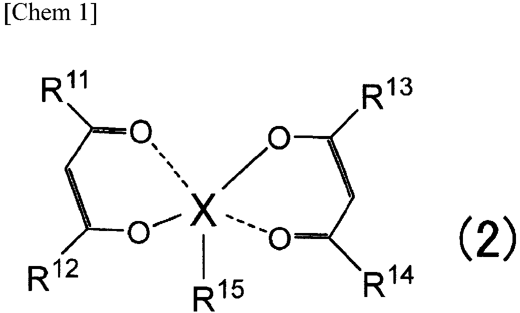 (In formula (2), R¹¹, R¹², R¹³, and R¹⁴ each independently represent a hydrogen atom, a halogen atom, or a hydrocarbon group having 1 to 10 carbon atoms. R¹⁵ represents a halogen atom, a formyl group, an acetoxy group, a sulfo group, a mesyl group, a nitro group, a nitroso group, a phosphoryl group, or an alkyl group having 1 to 6 carbon atoms. X represents gallium, iridium, indium, rhodium, titanium, or germanium.) 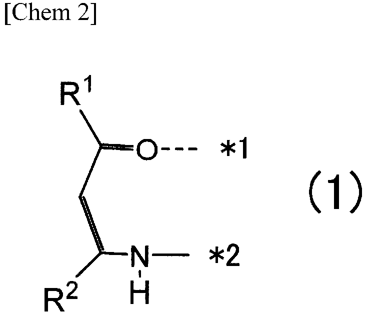 (In formula (1), R¹ and R² each independently represent an aliphatic hydrocarbon group having 1 to 6 carbon atoms. *1 represents a coordinate bond site with the metal atom. *2 represents a covalent bond site with the metal atom.)

Another invention made to solve the above problems is a method for storing a composition which is a method for storing the composition described above. The method includes processes of: filling the composition into a container so that a ratio of a volume of a void excluding a volume occupied by the composition to an internal volume of the container is 5% by volume or more and 20% by volume or less, and adjusting an oxygen concentration in the void to 0% by volume or more and 5% by volume or less; and storing the container filled with the composition at a temperature of 5 °C or higher and 40 °C or lower.

Still another invention made to solve the above problems is a compound represented by formula (3) below. 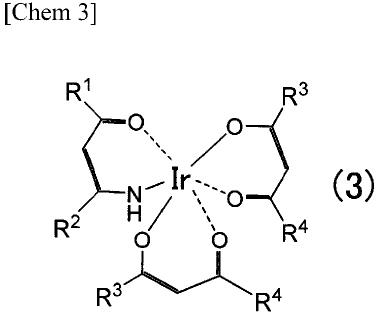 (In formula (3), R¹, R², R³, and R⁴ each independently represent an aliphatic hydrocarbon group having 1 to 6 carbon atoms.)

Still another invention made to solve the above problems is a compound represented by formula (2-1) below.

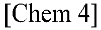

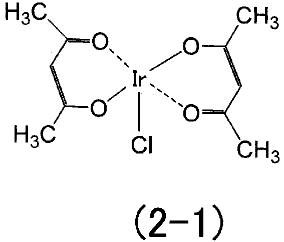

### Effects of Invention

The composition of the present invention is excellent in both solubility in an aqueous solvent and storage stability. According to the method for storing of the present invention, precipitation of a metal complex can be prevented even in the case of long-term storage of the composition described above. The compound of the present invention can be suitably used as a component of the composition described above.

### BRIEF DESCRIPTION OF THE DRAWINGS

[FIG. 1] FIG. 1 is a ¹H-NMR spectrum of an iridium complex obtained in Synthesis Example 1.
[FIG. 2] FIG. 2 is a Fourier transform infrared spectroscopy (FT-IR) spectrum of the iridium complex obtained in Synthesis Example 1.
[FIG. 3] FIG. 3 is a measurement result of TG-DTA of iridium complex 1 used in Example 1.
[FIG. 4] FIG. 4 is a measurement result of TG-DTA of iridium complex 2 used in Comparative Example 1.

### DESCRIPTION OF THE EMBODIMENTS

Hereinafter, a composition of the present invention, a method for storing composition, and a compound of the present invention will be described in detail.

Regarding the description of upper and lower limits of numerical ranges in this specification, unless otherwise specified, the upper limit may be "or less" or "less than," and the lower limit may be "or more" or "more than." The upper limit values and lower limit values can be arbitrarily combined with the disclosed numerical values. In the case of indicating a numerical range using the symbol "~," it means a numerical range that includes the upper and lower limit numerical values. For example, "1~6 carbon atoms" means "1 or more and 6 or fewer carbon atoms."

### <Composition>

The composition contains: at least one compound (hereinafter also referred to as "[A] metal complex") selected from the group consisting of a compound (hereinafter also referred to as "[A1] metal complex") represented by formula (2) described later and a compound (hereinafter also referred to as "[A2] metal complex") having a metal atom and a ligand represented by formula (1) described later; and an aqueous solvent (hereinafter also referred to as "[B] aqueous solvent").

By containing the [A] metal complex, the composition exhibits high solubility in an aqueous solvent, does not precipitate even during long-term storage, and exhibits high storage stability. Furthermore, the composition exhibits excellent thermal stability.

The composition can be suitably used as a composition for forming a thin film by a chemical vapor deposition method such as chemical vapor deposition (CVD) and atomic layer deposition (ALD).

### [[A] Metal Complex]

The [A] metal complex is at least one compound selected from the group consisting of the [A1] metal complex and the [A2] metal complex. The composition may contain one type or two or more types of [A] metal complexes.

A content ratio of the [A] metal complex in the composition is preferably 1% by mass or more and 60% by mass or less, and more preferably 3% by mass or more and 40% by mass or less.

Hereinafter, the [A2] metal complex and the [A1] metal complex will be described in this order.

### [[A2] Metal Complex]

The [A2] metal complex is a compound having a metal atom (hereinafter also referred to as "metal atom (M)") and a ligand (hereinafter also referred to as "ligand (L)") represented by formula (1) described later.

### (Metal Atom (M))

The metal atom (M) is not particularly limited if the ligand (L) can be coordinated thereto, and examples include those belonging to groups II to XV in periods 3 to 6 of the periodic table. In this specification, the metal atom (M) includes not only a metal atom but also a metalloid atom.

Examples of the metal atom belonging to group II include magnesium and calcium. Examples of the metal atom belonging to group III include scandium and yttrium.

Examples of the metal atom belonging to group IV include titanium and zirconium.

Examples of the metal atom belonging to group V include tantalum.

Examples of the metal atom belonging to group VI include chromium, molybdenum, and tungsten. Examples of the metal atom belonging to group VII include manganese and rhenium.

Examples of the metal atom belonging to group VIII include iron and ruthenium.

Examples of the metal atom belonging to group IX include cobalt, rhodium, and iridium.

Examples of the metal atom belonging to group X include nickel, palladium, and platinum.

Examples of the metal atom belonging to group XI include copper, silver, and gold.

Examples of the metal atom belonging to group XII include zinc.

Examples of the metal atom belonging to group XIII include aluminum, gallium, and indium.

Examples of the metal atom belonging to group XIV include tin and lead, and examples of the metalloid atom belonging to group XIV include germanium.

Examples of the metal atom belonging to group XV include bismuth, and examples of the metalloid atom belonging to group XV include arsenic.

As the metal atom (M), at least one selected from the group consisting of iridium, gallium, indium, rhodium, aluminum, gold, silver, platinum, copper, iron, manganese, nickel, palladium, cobalt, ruthenium, chromium, molybdenum, tungsten, tantalum, zinc, lead, rhenium, titanium, tin, magnesium, calcium, arsenic, germanium, and zirconium is preferable.

Among them, iridium, gallium, or indium is preferable from the viewpoint of reactivity or availability, and iridium is more preferable from the viewpoint of further improving solubility in an aqueous solvent.

### (Ligand (L))

The ligand (L) is represented by formula (1) below. By the [A2] metal complex having the ligand (L), the composition can exhibit excellent solubility in an aqueous solvent and excellent storage stability. 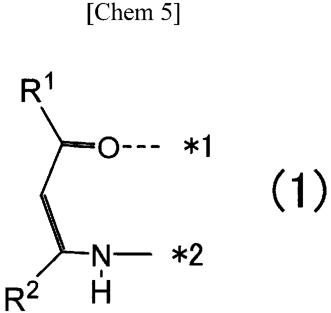 (In formula (1), R¹ and R² each independently represent an aliphatic hydrocarbon group having 1 to 6 carbon atoms. *1 represents a coordinate bond site with the metal atom. *2 represents a covalent bond site with the metal atom.)

In formula (1) above, R¹ and R² each independently represent an aliphatic hydrocarbon group having 1 to 6 carbon atoms. *1 represents a coordinate bond site with the metal atom. *2 represents a covalent bond site with the metal atom.

"Number of carbon atoms" refers to the number of carbon atoms constituting a group. "Aliphatic hydrocarbon group" includes "chain hydrocarbon group" and "alicyclic hydrocarbon group." "Aliphatic hydrocarbon group" includes "saturated hydrocarbon group" and "unsaturated hydrocarbon group." "Chain hydrocarbon group" refers to a hydrocarbon group composed only of a chain structure without including a ring structure, and includes both linear hydrocarbon group and branched hydrocarbon group. "Alicyclic hydrocarbon group" refers to a hydrocarbon group including only an alicyclic ring as a ring structure and without including an aromatic ring, and includes both monocyclic alicyclic hydrocarbon group and polycyclic alicyclic hydrocarbon group. However, alicyclic hydrocarbon group does not need to be composed only of an alicyclic structure, and may include a chain structure in part thereof.

Examples of the aliphatic hydrocarbon group having 1 to 6 carbon atoms represented by R¹ and R² include chain hydrocarbon group having 1 to 6 carbon atoms and alicyclic hydrocarbon group having 3 to 6 carbon atoms.

Examples of the chain hydrocarbon group having 1 to 6 carbon atoms include alkyl group such as methyl group, ethyl group, n-propyl group, isopropyl group, n-butyl group, isobutyl group, t-butyl group, n-pentyl group, and n-hexyl group. Examples of the alicyclic hydrocarbon group having 3 to 6 carbon atoms include cycloalkyl group such as cyclopropyl group, cyclobutyl group, cyclopentyl group, and cyclohexyl group.

As the aliphatic hydrocarbon group, alkyl group is preferable. Among alkyl groups, methyl group or ethyl group is preferable from the viewpoint of achieving both solubility and heat resistance.

The [A] metal complex may have other ligands than the ligand (L) in addition to the ligand (L). Examples of the other ligands include monodentate ligand and multidentate ligand.

Examples of the monodentate ligand include hydroxo ligand, carboxy ligand, amide ligand, and ammonia.

Examples of the multidentate ligand include hydroxy acid ester, β-diketone, β-ketoester, β-dicarboxylic acid ester, hydrocarbon having π bond, and diphosphine. As the β-diketone, acetylacetonate is preferable.

As the [A2] metal complex, a compound represented by formula (3) below is preferable.

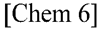

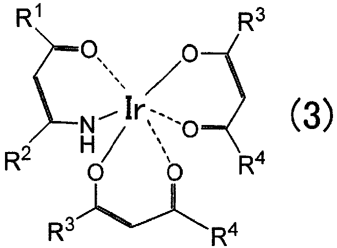

In formula (3) above, R¹, R², R³, and R⁴ each independently represent an aliphatic hydrocarbon group having 1 to 6 carbon atoms.

R¹ and R² in formula (3) above have the same meanings as R¹ and R² in formula (1) above.

In formula (3) above, among the lines bonded to the iridium atom (Ir), a solid line indicates a covalent bond and a broken line indicates a coordinate bond.

The aliphatic hydrocarbon group having 1 to 6 carbon atoms represented by R³ and R⁴ in formula (3) above is the same as the group described as R¹ and R² in formula (1) above. As the aliphatic hydrocarbon group, alkyl group is preferable. Among alkyl groups, methyl group or ethyl group is preferable from the viewpoint of achieving both solubility and heat resistance.

The [A2] metal complex can be synthesized, for example, by reacting a metal halide compound such as iridium trichloride with acetylacetonate in the presence of a water-soluble base compound such as ammonia or trimethylammonium hydroxide (TMAH).

The [A2] metal complex may exist in the form of a salt represented by formula (3-1) or formula (3-2) below in the [B] aqueous solvent. A countercation represented by Z⁺ in formulas (3-1) and (3-2) below is determined by a reagent used in neutralization treatment in synthesizing the [A2] metal complex. For example, in the case of using an aqueous ammonia solution, the countercation becomes an ammonium ion (NH4⁺); in the case of using hydrochloric acid, the countercation becomes a hydrogen ion (H⁺).

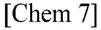

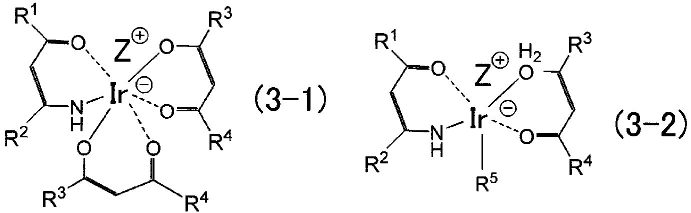

In formulas (3-1) and (3-2) above, R¹, R², R³, and R⁴ have the same meanings as in formula (3) above. Z⁺ represents a hydrogen ion or an ammonium ion.

In formula (3-2) above, R⁵ represents a halogen atom, a formyl group, an acetoxy group, a sulfo group, a mesyl group, a nitro group, a nitroso group, a phosphoryl group, or an aliphatic hydrocarbon group having 1 to 6 carbon atoms.

Examples of the halogen atom represented by R⁵ in formula (3-2) above include a fluorine atom, a chlorine atom, a bromine atom, and an iodine atom. The aliphatic hydrocarbon group having 1 to 6 carbon atoms represented by R⁵ is the same as the aliphatic hydrocarbon group having 1 to 6 carbon atoms represented by R¹, R², R³, and R⁴.

As R¹, R², R³, and R⁴, methyl group or ethyl group is preferable. As R⁵, chlorine atom is preferable.

As the compound represented by formula (3-1) above, a compound represented by formula (3-3) below is preferable.

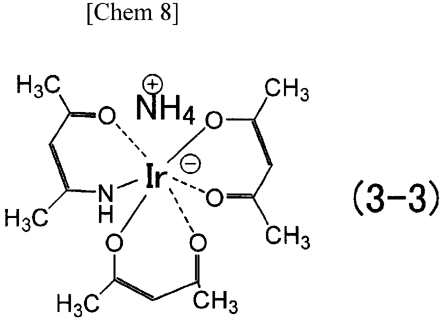

As the compound represented by formula (3-2) above, a compound represented by formula (3-4) below is preferable.

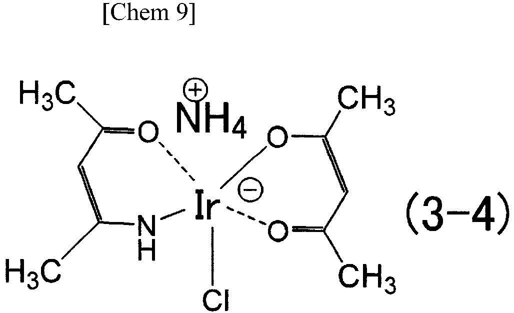

### [[A1] Metal Complex]

The [A1] metal complex is a compound represented by formula (2) below.

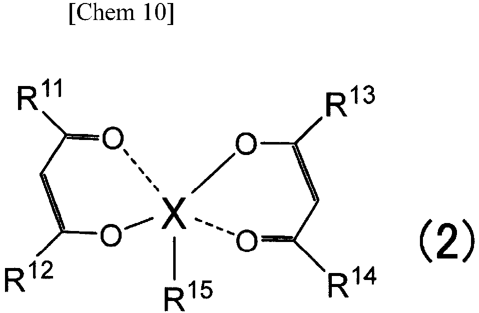

In formula (2) above, R¹¹, R¹², R¹³, and R¹⁴ each independently represent a hydrogen atom, a halogen atom, or a hydrocarbon group having 1 to 10 carbon atoms. R¹⁵ represents a halogen atom, a formyl group, an acetoxy group, a sulfo group, a mesyl group, a nitro group, a nitroso group, a phosphoryl group, or an alkyl group having 1 to 6 carbon atoms. X represents gallium, iridium, indium, rhodium, titanium, or germanium.

In formula (2) above, among the lines bonded to X, a solid line indicates a covalent bond and a broken line indicates a coordinate bond.

"Hydrocarbon group" includes "aliphatic hydrocarbon group" and "aromatic hydrocarbon group." "Aromatic hydrocarbon group" refers to a hydrocarbon group including an aromatic ring as a ring structure. However, aromatic hydrocarbon group does not need to be composed only of an aromatic ring, and may include a chain structure or alicyclic ring in part thereof.

Examples of the hydrocarbon group having 1 to 10 carbon atoms represented by R¹¹, R¹², R¹³, and R¹⁴ include chain hydrocarbon group having 1 to 20 carbon atoms, alicyclic hydrocarbon group having 3 to 10 carbon atoms, and aromatic hydrocarbon group having 6 to 10 carbon atoms.

Examples of the chain hydrocarbon group having 1 to 10 carbon atoms include alkyl group such as methyl group, ethyl group, n-propyl group, isopropyl group, n-butyl group, isobutyl group, t-butyl group, n-pentyl group, and n-hexyl group. Examples of the alicyclic hydrocarbon group having 3 to 10 carbon atoms include cycloalkyl group such as cyclopropyl group, cyclobutyl group, cyclopentyl group, and cyclohexyl group. Examples of the aromatic hydrocarbon group having 6 to 10 carbon atoms include aryl group such as phenyl group and tolyl group.

As the hydrocarbon group having 1 to 10 carbon atoms represented by R¹¹, R¹², R¹³, and R¹⁴, alkyl group having 1 to 6 carbon atoms, phenyl group, or tolyl group is preferable, and alkyl group having 1 to 6 carbon atoms is more preferable. From the viewpoint of achieving both solubility and heat resistance, methyl group or ethyl group is particularly preferable.

Examples of the halogen atom represented by R¹⁵ include a fluorine atom, a chlorine atom, a bromine atom, and an iodine atom.

The alkyl group having 1 to 6 carbon atoms represented by R¹⁵ includes linear alkyl group and branched alkyl group. Examples of the alkyl group having 1 to 6 carbon atoms include the same ones as described above.

As R¹⁵, a chlorine atom or acetoxy group is preferable from the viewpoint of further improving solubility and storage stability.

As X, iridium is preferable from the viewpoint of further improving solubility.

As the [A1] metal complex, a compound represented by formula (2-1) or formula (2-2) below is preferable.

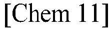

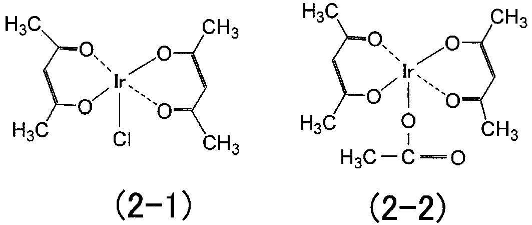

In formulas (2-1) and (2-2) above, among the lines bonded to the iridium atom (Ir), a solid line indicates a covalent bond and a broken line indicates a coordinate bond.

The [A1] metal complex can be synthesized, for example, by reacting a metal halide compound such as iridium trichloride with acetylacetonate in the presence of a water-soluble base compound such as ammonia or trimethylammonium hydroxide (TMAH) and a water-soluble acid compound such as hydrochloric acid.

The [A1] metal complex may exist in the form of a salt represented by formula (4) below in the [B] aqueous solvent. Accordingly, the composition may further contain a compound represented by formula (4) below. The countercation represented by Z⁺ in formula (4) below is determined by a reagent used in neutralization treatment in synthesizing the [A1] metal complex. For example, in the case of using an aqueous ammonia solution, the countercation becomes an ammonium ion (NH4⁺); in the case of using hydrochloric acid, the countercation becomes a hydrogen ion (H⁺).

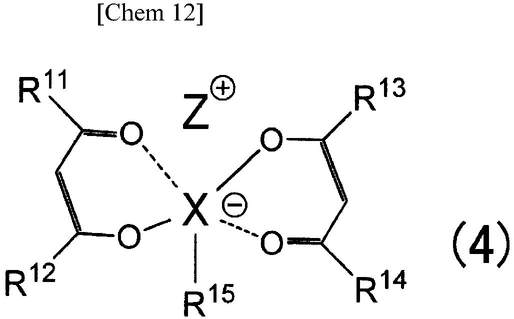

In formula (4) above, R¹¹, R¹², R¹³, R¹⁴, R¹⁵ and X have the same meanings as in formula (2) above. Z⁺ represents a hydrogen ion or an ammonium ion.

As the compound represented by formula (4) above, a compound represented by formula (4-1) or formula (4-2) below is preferable.

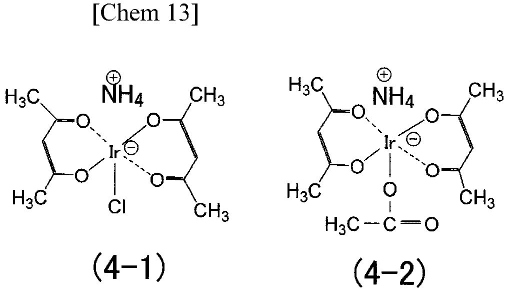

### [[B] Aqueous Solvent]

The [B] aqueous solvent means: (1) water; or (2) a mixed solvent containing water and an organic solvent and having water as a main component. "Having water as a main component" means that a content ratio of water in the [B] aqueous solvent is 50% by mass or more.

The organic solvent is not particularly limited if it is miscible with water, and examples include lower alcohol such as methanol, ethanol, and isopropanol.

The [B] aqueous solvent preferably does not substantially contain an organic solvent, and more preferably does not contain an organic solvent at all. "Does not substantially contain an organic solvent" is an expression that allows the composition to contain an organic solvent to an extent that does not cause flammability problems.

A content ratio of the organic solvent in the [B] aqueous solvent is preferably 10% by mass or less, more preferably 5% by mass or less, further preferably 1% by mass or less, still more preferably 0.1% by mass or less, and particularly preferably 0% by mass, with respect to the total amount of the [B] aqueous solvent.

**In** other words, the content ratio of water in the [B] aqueous solvent is preferably 90% by mass or more, more preferably 95% by mass or more, further preferably 99% by mass or more, still more preferably 99.9% by mass, and particularly preferably 100% by mass, with respect to the total amount of the [B] aqueous solvent.

### [Physical Properties of Composition]

The composition preferably has a pH of 4.0 or more and 7.5 or less. In the case of the pH being 4.0 or more, a decrease in solubility due to ligand exchange reaction of the [A] metal complex in the composition can be suppressed. In the case of the pH being 7.5 or less, formation of a thin film using the composition becomes easy.

### <Method for Storing Composition>

The method for storing a composition is a method for storing the composition described above, and includes: a process (hereinafter also referred to as "filling process") of filling the composition into a container so that a ratio of a volume of a void excluding a volume occupied by the composition to an internal volume of the container is 5% by volume or more and 20% by volume or less, and adjusting an oxygen concentration in the void to 0% by volume or more and 5% by volume or less; and a process (hereinafter also referred to as "storage process") of storing the container filled with the composition at a temperature of 5 °C or higher and 40 °C or lower.

In the filling process, the composition is filled into the container so that the ratio of the volume of the void excluding the volume occupied by the composition to the internal volume of the container is 5% by volume or more and 20% by volume or less.

During filling, the oxygen concentration in the void is adjusted to 0% by volume or more and 5% by volume or less. Examples of a method for adjusting the oxygen concentration include a method in which a gas present in the void is replaced with an inert gas such as nitrogen gas. By adjusting the oxygen concentration in the present process, the composition can be stored for a long period while generation of precipitates is suppressed.

In the storage process, the container filled with the composition is stored at a temperature of 5 °C or higher and 40 °C or lower.

### <Compound>

The compound is a compound represented by formula (3) or formula (2-1) above. The compound is described in section "[A] Metal Complex" above.

### Examples

Hereinafter, the present invention will be specifically described based on examples. The present invention is not limited to these examples.

### <Synthesis of Iridium Complex>

### [Synthesis Example 1]

In accordance with the following method, a compound (hereinafter referred to as "iridium complex 1") represented by formula (5) below was synthesized.

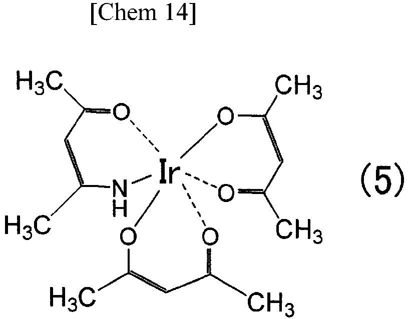

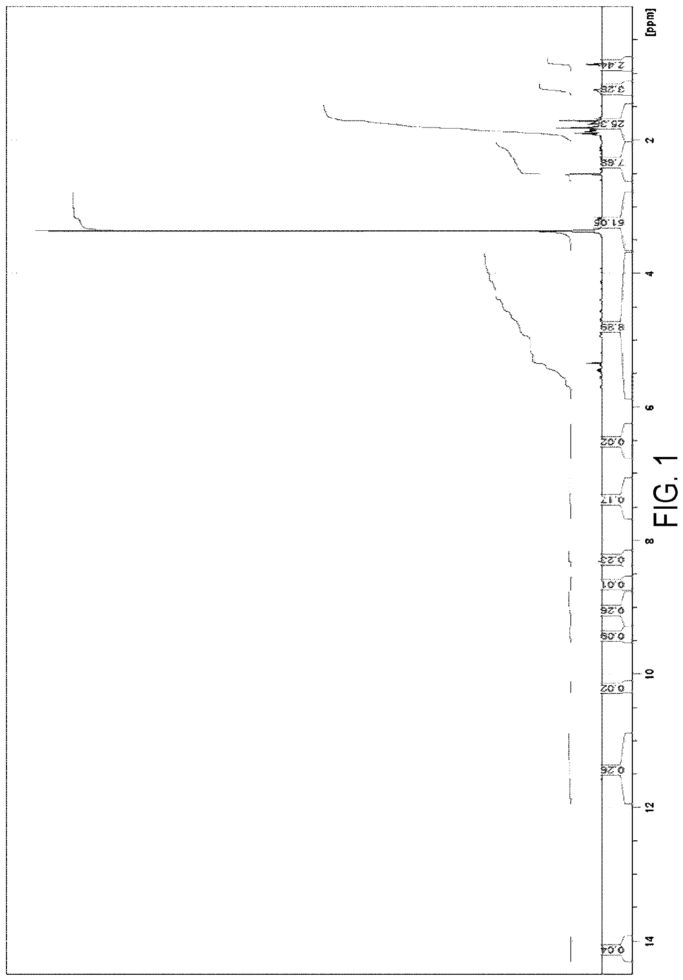

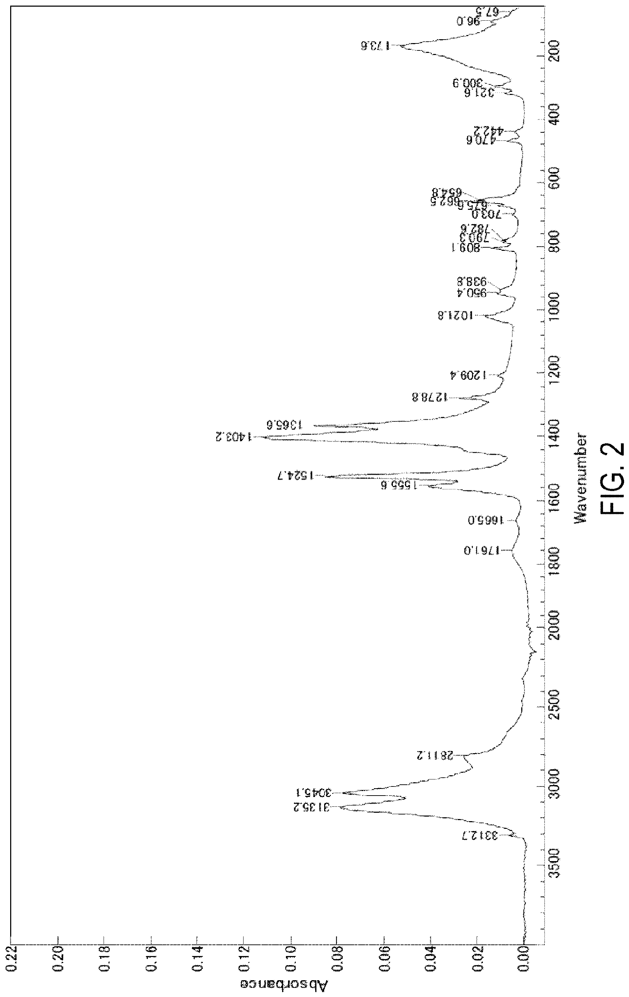

0.2 mol of iridium trichloride was dissolved in ultrapure water. This solution was heated to 70 °C, and 4.0 mol of acetylacetonate was added dropwise. An alkaline aqueous solution was added to the obtained mixed solution for neutralization treatment. The mixture was stirred overnight in the range of 80 °C to 110 °C. Thereafter, the reaction solution was filtered, and an organic solvent was added to the filtrate to extract a reaction product. The solvent of the extracted organic layer was distilled off. An organic solvent was added to the residue, and the mixture was purified to obtain iridium complex 1. The yield was 35% by mass. The structure was identified and determined using an LC-Mass spectrometer ("UltiMate 3000" from Thermo Fisher Scientific), ¹H-NMR ("AV 700" from Bruker Corporation), and FT-IR ("VERTEX 70v" from Bruker Corporation). An ¹H-NMR spectrum is shown in FIG. 1, and an FT-IR spectrum is shown in FIG. 2. As a result of the above identification, it was confirmed that compounds represented by formulas (5-1) to (5-3) below were contained as by-products.

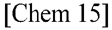

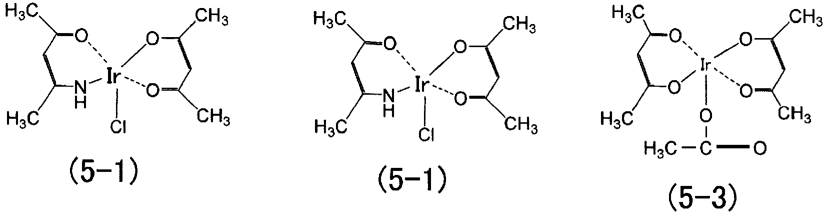

### [Synthesis Example 2]

In accordance with the following method, a compound (hereinafter referred to as "iridium complex 2") represented by formula (2-1) below was synthesized.

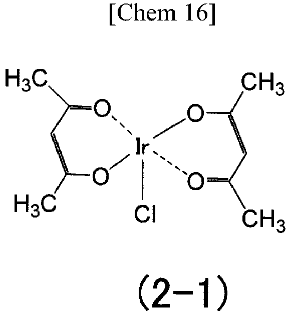

0.2 mol of iridium trichloride was dissolved in ultrapure water. This solution was heated to 60 °C, and 1.5 mol of acetylacetonate was added dropwise. An alkaline aqueous solution and an acidic aqueous solution were added to the obtained mixed solution for neutralization treatment so that a pH of around 7 was achieved. The mixture was stirred overnight in the range of 80 °C to 110 °C. Thereafter, the reaction solution was filtered, and an organic solvent was added to the filtrate to extract a reaction product. The solvent of the extracted organic layer was distilled off. An organic solvent was added to the residue, and the mixture was purified to obtain iridium complex 2. The yield was 35% by mass. The structure was identified and determined using an LC-Mass spectrometer ("UltiMate 3000" from Thermo Fisher Scientific), ¹H-NMR ("AV 700" from Bruker Corporation), and FT-IR ("VERTEX 70v" from Bruker Corporation). As a result of the above identification, it was confirmed that compounds represented by formulas (2-4) and (2-5) below were contained as by-products.

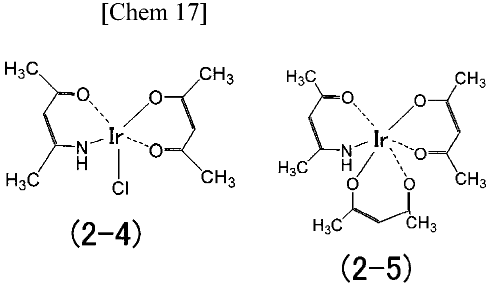

### <Preparation of Composition>

### [Example 1]

Iridium complex 1 obtained in Synthesis Example 1 was dissolved in water under conditions of room temperature and ultrasonic treatment for 2 hours to obtain an aqueous solution (hereinafter referred to as "Ir aqueous solution 1") containing iridium complex 1 (concentration: 3% by mass). In Ir aqueous solution 1, iridium complex 1 was well dissolved in water during preparation. The pH of the obtained Ir aqueous solution 1 was measured using a pH measuring device. The pH of Ir aqueous solution 1 was 4.5.

### [Example 2]

Iridium complex 2 obtained in Synthesis Example 2 was dissolved in water under conditions of room temperature and ultrasonic treatment for 2 hours to obtain an aqueous solution (hereinafter referred to as "Ir aqueous solution 2") containing iridium complex 2. In Ir aqueous solution 2, iridium complex 2 was well dissolved in water during preparation. The pH of the obtained Ir aqueous solution 2 was measured using a pH measuring device. The pH of Ir aqueous solution 2 was 6.5.

### [Comparative Example 1]

Except that a compound (hereinafter referred to as "iridium complex 3") represented by formula (6) below was used instead of iridium complex 1 and iridium complex 2, an aqueous solution (hereinafter referred to as "Ir aqueous solution 3") containing iridium complex 3 was prepared in the same manner as Example 1 and Example 2. However, iridium complex 3 did not dissolve in water. This is considered to be due to a difference in ligand between iridium complex 1 or iridium complex 2 and iridium complex 3.

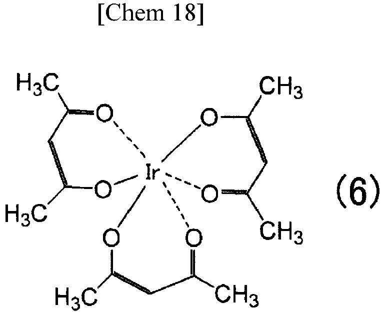

### [Evaluation of Decomposition Characteristics of Complexes (With Respect to Iridium Complex 1 and Iridium Complex 3)]

With respect to iridium complex 1 and iridium complex 3, thermogravimetric-differential thermal analysis (TG-DTA) was performed in an air atmosphere, and decomposition characteristics of the complexes were evaluated. In this evaluation test, "STA 2500 Regulus" from NETZSCH was used as an analytical instrument, an iridium complex sample (sample mass: 10 mg) was filled into an alumina cell, and a change in mass was observed at a heating rate of 20 °C/min and a measurement temperature range from room temperature to 1000 °C.

As a result of measurement in an air atmosphere, since it was confirmed that iridium complex 1 exhibited an exothermic peak on the high temperature side compared to iridium complex 3, it is clear that iridium complex 1 had high heat resistance. Furthermore, since it was confirmed that iridium complex 1 was reduced in mass at a temperature equivalent to iridium complex 3, it is clear that iridium complex 1 had good vaporization characteristics and decomposition temperature. Since iridium complex 1 had good vaporization characteristics and decomposition temperature, it is considered that film formation is possible at relatively low temperatures by CVD or the like.

### [Evaluation of Decomposition Characteristics of Complexes (With Respect to Iridium Complex 2 and Iridium Complex 3)]

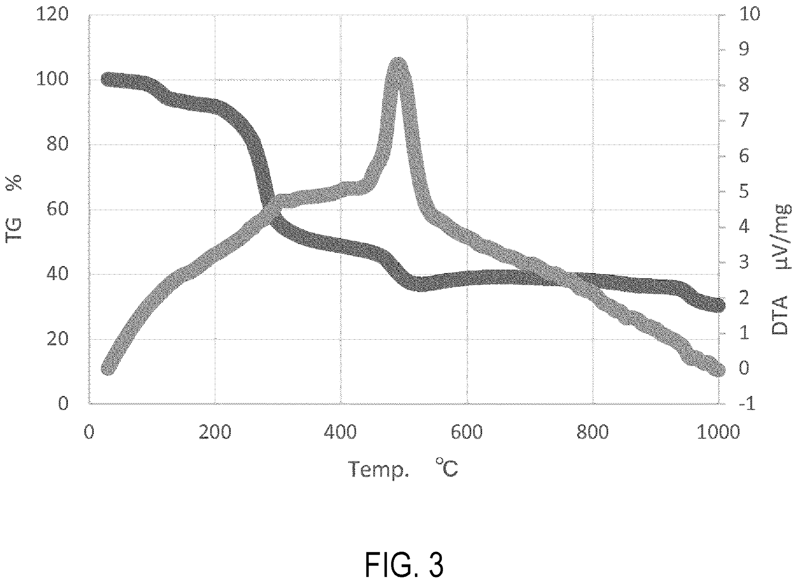

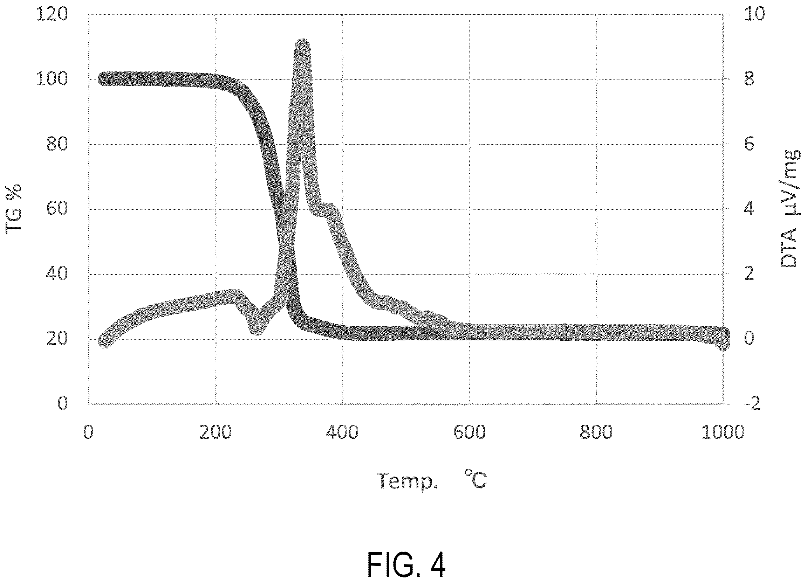

With respect to iridium complex 2 and iridium complex 3, thermogravimetric-differential thermal analysis (TG-DTA) was performed in an air atmosphere, and decomposition characteristics of the complexes were evaluated. In this evaluation test, "STA 2500 Regulus" from NETZSCH was used as an analytical instrument, an iridium complex sample (sample mass: 10 mg) was filled into an alumina cell, and a change in mass was observed at a heating rate of 20 °C/min and a measurement temperature range from room temperature to 1000 °C. A measurement result of iridium complex 2 is shown in FIG. 3, and a measurement result of iridium complex 3 is shown in FIG. 4.

As a result of measurement in an air atmosphere, since it was confirmed that iridium complex 2 (FIG. 3) exhibited an exothermic peak on the high temperature side compared to iridium complex 3 (FIG. 4), it is clear that iridium complex 2 had high heat resistance. From these results, it is considered that a film formed from Ir aqueous solution 2 exhibits higher heat resistance than a film formed from Ir aqueous solution 3. Furthermore, since it was confirmed that iridium complex 2 was reduced in mass at a temperature equivalent to iridium complex 3, it is clear that iridium complex 2 had good vaporization characteristics and decomposition temperature. Since iridium complex 1 had good vaporization characteristics and decomposition temperature, it is considered that film formation is possible at relatively low temperatures by CVD or the like.

### [Evaluation of Storage Stability]

As storage test sample 1, filling was performed so that a ratio of the volume of a void in a container for Ir aqueous solution 1 and Ir aqueous solution 2 became 70%. The void was replaced with nitrogen and sealed, and stored at 23 °C for 30 days. As storage test sample 2, filling was performed so that a ratio of the volume of a void in a container for Ir aqueous solution 1 and Ir aqueous solution 2 became 70%. The void was replaced with oxygen and sealed, and stored at 23 °C for 30 days. After 30 days elapsed, storage test sample 1 and storage test sample 2 were visually observed for liquid color and presence or absence of precipitates.

The liquid color was pale yellow in both storage test sample 1 and storage test sample 2. Regarding the presence or absence of precipitates, no precipitates were confirmed in storage test sample 1, while black foreign matter was observed in storage test sample 2. This suggests that oxygen affects the generation of foreign matter, and it is clear that storage stability can be improved by controlling the oxygen concentration in the container.

## Claims

1. A composition, comprising:
at least one compound selected from a group consisting of a first compound represented by formula (2) below and a second compound having a metal atom and a ligand represented by formula (1) below; and
an aqueous solvent, 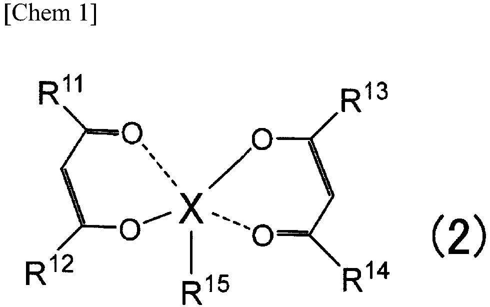
(wherein in formula (2), R¹¹, R¹², R¹³, and R¹⁴ each independently represent a hydrogen atom, a halogen atom, or a hydrocarbon group having 1 to 10 carbon atoms; R¹⁵ represents a halogen atom, a formyl group, an acetoxy group, a sulfo group, a mesyl group, a nitro group, a nitroso group, a phosphoryl group, or an alkyl group having 1 to 6 carbon atoms; and X represents gallium, iridium, indium, rhodium, titanium, or germanium,) 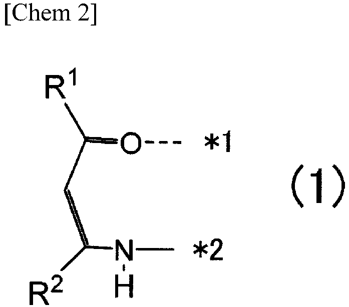
(wherein in formula (1), R¹ and R² each independently represent an aliphatic hydrocarbon group having 1 to 6 carbon atoms; *1 represents a coordinate bond site with the metal atom; and *2 represents a covalent bond site with the metal atom.)

2. The composition according to claim 1, wherein
X in formula (2) is iridium.

3. The composition according to claim 1, wherein
the first compound is represented by formula (2-1) or formula (2-2) below,

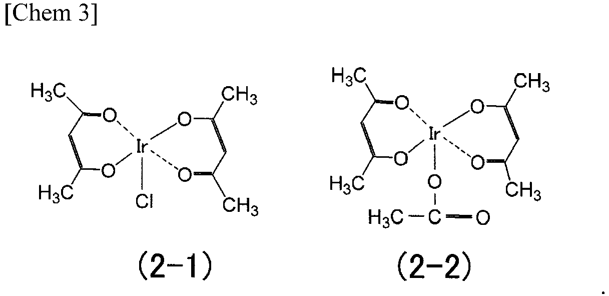

4. The composition according to claim 1, further comprising:
a third compound represented by formula (4) below, 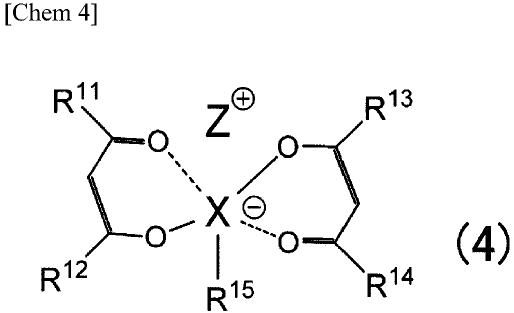
(wherein in formula (4), R¹¹, R¹², R¹³, R¹⁴, R¹⁵, and X have the same meanings as in formula (2); and Z⁺ represents a hydrogen ion or an ammonium ion.)

5. The composition according to claim 4, wherein the third compound is represented by formula (4-1) or formula (4-2) below,

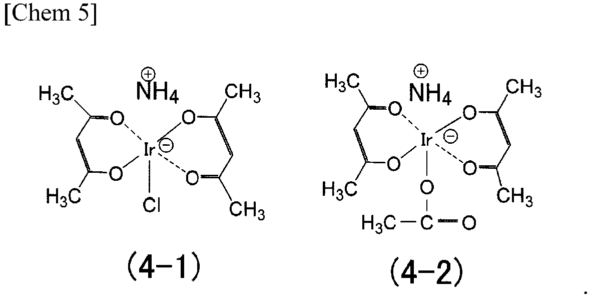

6. The composition according to claim 1, wherein
the metal atom in the second compound belongs to groups II to XV in periods 3 to 6 of a periodic table.

7. The composition according to claim 1, wherein
the metal atom in the second compound is at least one selected from a group consisting of iridium, gallium, indium, rhodium, aluminum, gold, silver, platinum, copper, iron, manganese, nickel, palladium, cobalt, ruthenium, chromium, molybdenum, tungsten, tantalum, zinc, lead, rhenium, titanium, tin, magnesium, calcium, arsenic, germanium, and zirconium.

8. The composition according to claim 1, wherein
the metal atom in the second compound is iridium.

9. The composition according to claim 8, wherein
the second compound is represented by formula (3) below, 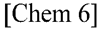 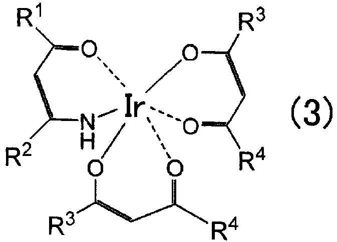
(wherein in formula (3), R¹, R², R³, and R⁴ each independently represent an aliphatic hydrocarbon group having 1 to 6 carbon atoms.)

10. The composition according to claim 8, wherein
the second compound is represented by formula (3-1) or formula (3-2) below, 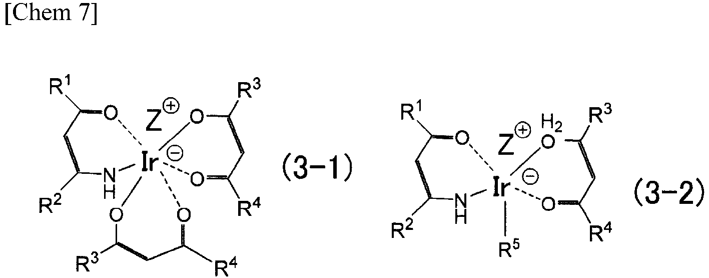
(wherein in formulas (3-1) and (3-2), R¹, R², R³, and R⁴ each independently represent an aliphatic hydrocarbon group having 1 to 6 carbon atoms; and Z⁺ represents a hydrogen ion or an ammonium ion; and
in formula (2-2), R⁵ represents a halogen atom, a formyl group, an acetoxy group, a sulfo group, a mesyl group, a nitro group, a nitroso group, a phosphoryl group, or an aliphatic hydrocarbon group having 1 to 6 carbon atoms.)

11. The composition according to claim 10, wherein
the compound represented by formula (3-1) is represented by formula (3-3) below,

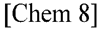

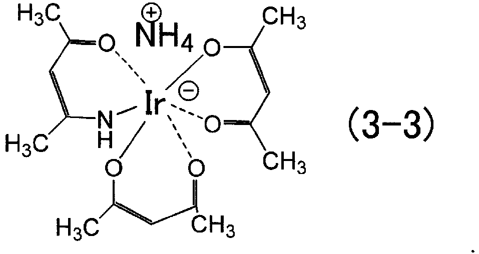

12. The composition according to claim 10, wherein
the compound represented by formula (3-2) is represented by formula (3-4) below,

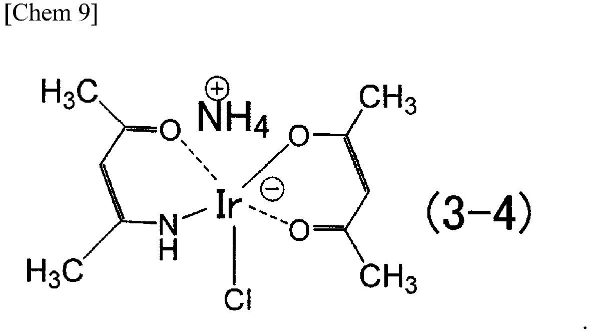

13. The composition according to claim 1, wherein
the aqueous solvent does not substantially contain an organic solvent.

14. The composition according to claim 1, having a pH of 4.0 or more and 7.5 or less.

15. A method for storing the composition according to any one of claims 1 to 14, comprising processes of:
filling the composition into a container so that a ratio of a volume of a void excluding a volume occupied by the composition to an internal volume of the container is 5% by volume or more and 20% by volume or less, and adjusting an oxygen concentration in the void to 0% by volume or more and 5% by volume or less; and
storing the container filled with the composition at a temperature of 5 °C or higher and 40 °C or lower.

16. A compound, represented by formula (3) below, 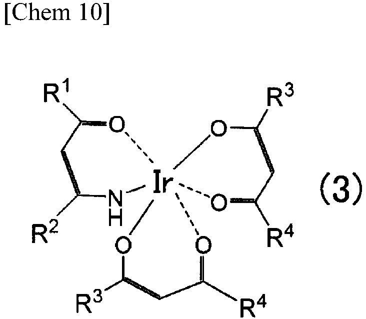 (wherein in formula (3), R¹, R², R³, and R⁴ each independently represent an aliphatic hydrocarbon group having 1 to 6 carbon atoms.)

17. A compound, represented by formula (2-1) below,
